# EUROPEAN PATENT APPLICATION

(11) **EP 4 636 448 A1**
(43) Date of publication of application: **22.10.2025**
(21) Application number: 23902664.4
(22) Date of filing: 11.12.2023
(51) Int. Cl.: G02B 6/42, H01L 23/31

(54) **PACKAGING STRUCTURE AND MANUFACTURING METHOD THEREFOR**

(30) Priority: 12.12.2022 CN 202211610924
(71) Applicant: Nanjing Guangzhiyuan Technology Co., Ltd., Nanjing, Jiangsu 211899 (CN)
(72) Inventor: MENG, Huaiyu, Nanjing, Jiangsu 211899 (CN); SHEN, Yichen, Nanjing, Jiangsu 211899 (CN); YAN, Qixin, Nanjing, Jiangsu 211899 (CN); JIANG, Lushan, Nanjing, Jiangsu 211899 (CN); WU, Jianhua, Nanjing, Jiangsu 211899 (CN)
(74) Representative: Nederlandsch Octrooibureau
(86) International application number: PCT/CN2023/137997
(87) International publication number: WO 2024/125468

(57) **Abstract**

An encapsulation structure and manufacturing method thereof are disclosed. The method includes providing a semiconductor wafer including a plurality of first semiconductor chips. For each first semiconductor chip, a microlens is formed on a second semiconductor chip or a dummy chip covering an optical coupling region to correct light input into the optical coupling region for optical coupling. The material of the second semiconductor chip or the dummy chip covering the optical coupling region is transparent to light of a predetermined wavelength. The microlens can focus light incident on it onto the optical coupling interface, significantly lowering the requirements for subsequent optical coupling precision. It also improves the efficiency of the surface coupling process and increases the tolerance for placement alignment errors of die attach equipment.

## Description

The present application claims priority to Chinese Patent Application No. 202211610924.4, filed on December 12, 2022, entitled "Encapsulation Structure and Manufacturing Method Thereof," the entire content of which is incorporated herein by reference.

### Technical Field

The present application relates to the field of semiconductor encapsulation, and in particular, to an encapsulation structure and a manufacturing method thereof.

### Related Art

With the continuous advancement of semiconductor technology, encapsulation structures with high integration density have become increasingly important. For example, 3D encapsulation structures enable chip-to-chip stacking.

In current silicon photonic chips, electronic integrated circuit chips (EIC chips) and photonic integrated circuit chips (PIC chips) are manufactured using different wafer fabrication processes. Chip-level interconnections, such as wire bonding or flip-chip bonding, are employed to connect EIC chips and PIC chips, forming three-dimensional interconnection structures.

To shorten signal transmission paths and achieve adequate electrical performance, the trend is increasingly shifting toward 3D stacked interconnections for PIC-EIC chip connections, replacing traditional wire bonding. However, when optical fiber structures are coupled to PIC chips using surface coupling (e.g., coupling with a grating coupler, GC for short), space must be reserved for coupling, and the coupling surface must be free of organic residues that could obstruct light transmission. In contrast, 3D stacked interconnections typically involve a molding process, where the surface of the PIC chip facing the EIC chip is entirely encapsulated by a molding layer to provide physical protection to both chips. This creates a conflict between the requirements for coupling space and physical protection. Additionally, the mainstream surface coupling process involves passive alignment to position the optical fiber structure within a certain range of the target position, followed by active alignment to optimize coupling efficiency based on data feedback. The whole surface-coupling process is less efficient. Moreover, to control the coupling loss of the grating coupler within 1 dB, the placement accuracy of the die attach equipment in the X-Y direction must be within ±2.5 µm, imposing stringent requirements on placement precision.

### SUMMARY

Embodiments of the present application provide an encapsulation structure and a manufacturing method thereof.

In an exemplary embodiment, a manufacturing method of an encapsulation structure is provided, including:
providing a semiconductor wafer, the semiconductor wafer comprising a plurality of first semiconductor chips, each of the first semiconductor chips including a first surface and a second surface that are arranged opposite each other, the first surface being provided with an optical coupling region and a non-optical coupling region surrounding the optical coupling region, the optical coupling region comprising an optical coupling interface;
for each of the first semiconductor chips, providing at least one second semiconductor chip corresponding to the first semiconductor chip and fixing the at least one second semiconductor chip on the first surface of the first semiconductor chip, wherein one of the second semiconductor chips corresponding to the first semiconductor chip includes a dummy region, the dummy region is a circuit-free area, the shape of the dummy region being adapted to the shape of the optical coupling region, and the dummy region of the second semiconductor chip is positioned to cover the optical coupling region, wherein a material of the second semiconductor chip covering the optical coupling region is transparent to light of a predetermined wavelength;
forming a molding layer, wherein the molding layer exposes a surface of each second semiconductor chip facing away from the first semiconductor chip; and
for each of the first semiconductor chips, forming a first microlens on the dummy region of the second semiconductor chip corresponding to the optical coupling region to correct light input into the optical coupling region for optical coupling.

In some embodiments, a curvature of the first microlens and a distance between the first microlens and the optical coupling interface are adjusted to focus light incident on the first microlens onto the optical coupling interface.

In some embodiments, for each second semiconductor chip covering the optical coupling region, the material of the second semiconductor chip includes silicon.

In some embodiments, the step of forming the first microlens on the dummy region of the second semiconductor chip corresponding to the optical coupling region for each first semiconductor chip includes:
forming a photoresist layer on the exposed surface of each second semiconductor chip;
performing patterned photolithography on the photoresist layer using a mask process to form an arc-shaped protrusion structure corresponding to the optical coupling region in the remaining photoresist layer; and
etching the arc-shaped protrusion structure using an etching process to form the first microlens on each second semiconductor chip corresponding to the optical coupling region.

In some embodiments, the manufacturing method further includes: before fixing the at least one second semiconductor chip on the first surface of the first semiconductor chip, forming a plurality of metal connection pillars in each first semiconductor chip, wherein one side surface of each metal connection pillar is exposed from the surface of the first semiconductor chip.

In some embodiments, fixing the at least one second semiconductor chip on the first semiconductor chip includes fixing the at least one second semiconductor chip on the first surface of the first semiconductor chip using hybrid bonding.

In some embodiments, the manufacturing method further includes: after forming the first microlens on the dummy region of the second semiconductor chip corresponding to the optical coupling region for each first semiconductor chip, temporarily bonding a surface of each second semiconductor chip facing away from the first semiconductor chip to a first carrier substrate using a temporary bonding adhesive; thinning a body of the first semiconductor chip on a side away from the at least one second semiconductor chip to expose a surface of the metal connection pillars facing away from the at least one second semiconductor chip; and after exposing the surface of the metal connection pillars, forming a first conductive bump on the exposed surface of each metal connection pillar.

In some embodiments, the manufacturing method further includes: after forming the first conductive bump on the exposed surface of each metal connection pillar, debonding the first carrier substrate; attaching a surface of each second semiconductor chip facing away from the first semiconductor chip to a dicing tape; and dicing at a position of dicing streets between adjacent first semiconductor chips to obtain a plurality of separated chip encapsulation assemblies, wherein each chip encapsulation assembly includes one first semiconductor chip and at least one corresponding second semiconductor chip.

In some embodiments, the manufacturing method further includes: after obtaining the plurality of separated chip encapsulation assemblies, mounting each chip encapsulation assembly onto a corresponding encapsulation substrate; after mounting the chip encapsulation assembly onto the corresponding encapsulation substrate, mounting an optical fiber structure onto the first microlens.

In another exemplary embodiment, a manufacturing method of an encapsulation structure is provided, including:
providing a semiconductor wafer, the semiconductor wafer comprising a plurality of first semiconductor chips, each of the first semiconductor chips comprising a first surface and a second surface that are arranged opposite each other, the first surface being provided with an optical coupling region and a non-optical coupling region surrounding the optical coupling region, the optical coupling region including an optical coupling interface;
for each of the first semiconductor chips, providing at least one dummy chip corresponding to the first semiconductor chip and fixing the at least one dummy chip on the first surface of the first semiconductor chip, wherein one dummy chip corresponding to the first semiconductor chip covers the optical coupling region, and a material of the dummy chip covering the optical coupling region is transparent to light of a predetermined wavelength;
forming a molding layer, wherein the molding layer exposes a surface of each dummy chip facing away from the first semiconductor chip; and
for each of the first semiconductor chips, forming a second microlens on the dummy chip corresponding to the optical coupling region to correct light input into the optical coupling region for optical coupling.

In some embodiments, for each first semiconductor chip, providing at least one second semiconductor chip corresponding to the first semiconductor chip and fixing the at least one second semiconductor chip on the non-optical coupling region of the first surface of the first semiconductor chip.

In some embodiments, a curvature of the second microlens and a distance between the second microlens and the optical coupling interface are adjusted to focus light incident on the second microlens onto the optical coupling interface.

In some embodiments, for each dummy chip covering the optical coupling region, the material of the dummy chip includes silicon or glass.

In some embodiments, in a direction perpendicular to the first surface of the corresponding first semiconductor chip, a top surface of the at least one dummy chip facing away from the first surface is flush with a top surface of the at least one second semiconductor chip facing away from the first surface.

In some embodiments, the step of forming the second microlens on the dummy chip corresponding to the optical coupling region for each first semiconductor chip includes:
forming a photoresist layer on the exposed surface of each dummy chip;
performing patterned photolithography on the photoresist layer using a mask process to form an arc-shaped protrusion structure corresponding to the optical coupling region in the remaining photoresist layer; and
etching the arc-shaped protrusion structure using an etching process to form the second microlens on each dummy chip corresponding to the optical coupling region.

In some embodiments, the manufacturing method further includes: before fixing the at least one second semiconductor chip on the first surface of the first semiconductor chip, forming a plurality of metal connection pillars in each first semiconductor chip, wherein one side surface of each metal connection pillar is exposed from the surface of the first semiconductor chip.

In some embodiments, fixing the at least one second semiconductor chip and the at least one dummy chip on the first semiconductor chip includes: fixing the at least one second semiconductor chip on the first surface of the first semiconductor chip using thermal compression bonding, reflow soldering, or hybrid bonding; and fixing each dummy chip on the first semiconductor chip using hybrid bonding.

In some embodiments, the manufacturing method further includes: after forming the second microlens on the dummy chip corresponding to the optical coupling region for each first semiconductor chip, temporarily bonding the surface of each dummy chip facing away from the first semiconductor chip to a first carrier substrate using a temporary bonding adhesive; thinning a body of the first semiconductor chip on a side away from the at least one dummy chip to expose a surface of the metal connection pillars facing away from the at least one dummy chip; and after exposing the surface of the metal connection pillars, forming a second conductive bump on the exposed surface of each metal connection pillar.

In some embodiments, the manufacturing method further includes: after forming the second conductive bumps on the exposed surface of each metal connection pillar, debonding the first carrier substrate; attaching the surface of each second semiconductor chip and each dummy chip facing away from the first semiconductor chip to a dicing tape; and dicing at a position of dicing streets between adjacent first semiconductor chips to obtain a plurality of separated chip encapsulation assemblies, each chip encapsulation assembly comprising one first semiconductor chip and at least one corresponding dummy chip.

In some embodiments, the method further includes: after obtaining the plurality of separated chip encapsulation assemblies, mounting each chip encapsulation assembly onto a corresponding substrate; and after mounting the chip encapsulation assembly onto the corresponding substrate, mounting an optical fiber structure onto the second microlens.

In an exemplary embodiment, an encapsulation structure is provided, including:
a first semiconductor chip comprising a first surface and a second surface that are arranged opposite each other, the first surface being provided with an optical coupling region and a non-optical coupling region surrounding the optical coupling region, the optical coupling region including an optical coupling interface;
at least one second semiconductor chip fixed on the first surface, wherein one second semiconductor chip corresponding to the first semiconductor chip includes a dummy region, the dummy region is a circuit-free area, the shape of the dummy region is adapted to the shape of the optical coupling region and covering the optical coupling region, and a material of the second semiconductor chip covering the optical coupling region is transparent to light of a predetermined wavelength;
a first microlens disposed on the dummy region of the second semiconductor chip corresponding to the optical coupling region.

In some embodiments, a curvature of the first microlens and a distance between the first microlens and the optical coupling interface are adjusted to focus light incident on the first microlens onto the optical coupling interface.

In some embodiments, for each second semiconductor chip covering the optical coupling region, the material of the second semiconductor chip includes silicon.

In some embodiments, a plurality of metal connection pillars are provided in each first semiconductor chip, and one side surface of each metal connection pillar is exposed from the surface of the first semiconductor chip.

In some embodiments, each metal connection pillar is electrically connected to a corresponding encapsulation substrate via a first conductive bump; the encapsulation structure further includes an optical fiber structure mounted on a surface of the first microlens facing away from the corresponding first semiconductor chip.

In another exemplary embodiment, an encapsulation structure is provided, including:
a first semiconductor chip comprising a first surface and a second surface that are arranged opposite each other, the first surface being provided with an optical coupling region and a non-optical coupling region surrounding the optical coupling region, the optical coupling region including an optical coupling interface;
at least one dummy chip fixed on the first surface, wherein one dummy chip corresponding to the first semiconductor chip covers the optical coupling region, and a material of the dummy chip covering the optical coupling region is transparent to light of a predetermined wavelength;
a molding layer located on the first surface of the first semiconductor chip and encapsulating a side surface of the at least one dummy chip; and
a second microlens formed on the dummy chip corresponding to the optical coupling region.

In some embodiments, the encapsulation structure further includes at least one second semiconductor chip fixed on the non-optical coupling region of the first surface of the first semiconductor chip.

In some embodiments, in a direction perpendicular to the first surface of the corresponding first semiconductor chip, a top surface of the at least one dummy chip facing away from the first surface is flush with a top surface of the at least one second semiconductor chip facing away from the first surface.

In some embodiments, a curvature of the second microlens and a distance between the second microlens and the optical coupling interface are adjusted to focus light incident on the second microlens onto the optical coupling interface.

In some embodiments, for each dummy chip covering the optical coupling region, the material of the dummy chip includes silicon or glass.

In some embodiments, a plurality of metal connection pillars are provided in each first semiconductor chip, and one side surface of each metal connection pillar is exposed from the surface of the first semiconductor chip.

In some embodiments, each metal connection pillar is electrically connected to a corresponding substrate via a second conductive bump; the encapsulation structure further includes an optical fiber structure mounted on a surface of the second microlens facing away from the corresponding first semiconductor chip.

In another exemplary embodiment, an encapsulation structure is provided, including:
a first semiconductor chip comprising a first surface and a second surface that are arranged opposite each other, the first surface being provided with an optical coupling region and a non-optical coupling region surrounding the optical coupling region, the optical coupling region including an optical coupling interface;
at least one dummy chip fixed on the first surface, wherein one dummy chip corresponding to the first semiconductor chip covers the optical coupling region, and a material of the dummy chip is transparent to light of a predetermined wavelength; and
an optical fiber structure disposed on the dummy chip corresponding to the optical coupling region, wherein an output end of the optical fiber structure includes third microlenses, each third microlens corresponding to an optical fiber in the optical fiber structure, configured to focus light emitted from the optical fiber structure onto the optical coupling interface.

In some embodiments, the encapsulation structure further includes a molding layer disposed on the first surface of the first semiconductor chip, the molding layer encapsulating at least a side surface of the at least one dummy chip.

In some embodiments, the encapsulation structure further includes at least one second semiconductor chip fixed on the non-optical coupling region of the first surface of the first semiconductor chip.

In some embodiments, for each dummy chip covering the optical coupling region, the material of the dummy chip includes silicon or glass.

In some embodiments, for each dummy chip covering the optical coupling region, an upper surface of the dummy chip includes an anti-reflective coating.

In some embodiments, a plurality of metal connection pillars are provided in each first semiconductor chip, one side surface of each metal connection pillar being exposed from the surface of the first semiconductor chip; and each metal connection pillar is electrically connected to a corresponding substrate via a second conductive bump.

The manufacturing method of the encapsulation structure provided by embodiments of the present invention includes: providing a semiconductor wafer, the semiconductor wafer comprising a plurality of first semiconductor chips; for each first semiconductor chip, forming a microlens on a second semiconductor chip or a dummy chip covering an optical coupling region to correct light input into the optical coupling region for optical coupling; wherein a material of the second semiconductor chip or the dummy chip covering the optical coupling region is transparent to light of a predetermined wavelength. Since the microlens can focus light incident on the microlens onto the optical coupling interface, it significantly lowers the requirements for subsequent optical coupling precision, improves the efficiency of the surface coupling process, and increases the tolerance for placement alignment errors of die attach equipment.

Another embodiment of the present invention provides an encapsulation structure, including a first semiconductor chip. The first semiconductor chip including opposing first and second surfaces, with an optical coupling region and a non-optical coupling region surrounding it on the first surface, and an optical coupling interface within the optical coupling region. An optical fiber structure, with third microlenses at its output end, is disposed on a dummy chip corresponding to the optical coupling region, to correct light input into the optical coupling region for optical coupling. Since the microlenses can focus light emitted from the optical fiber structure and transmit it through the dummy chip to the optical coupling interface, the requirements for subsequent optical coupling precision are significantly reduced, the efficiency of the surface coupling process is improved, and the tolerance for placement alignment errors of die attach equipment is increased. Additionally, the material of the dummy chip covering the optical coupling region has high transparency to light of a predetermined wavelength, resulting in minimal loss of light after passing through the microlenses focused light through the dummy chip. Furthermore, the dummy chip has a certain thickness, providing support for the optical fiber structure, significantly reducing the stress exerted by the optical fiber structure on the first semiconductor chip, and enhancing the stability of the encapsulation structure.

The aspects, features, and advantages of the embodiments of the present invention will be described in detail below with reference to the accompanying drawings. The above aspects, features, and advantages of the present invention will become more apparent from the following detailed description in conjunction with the drawings.

Specific embodiments of the present invention are disclosed in detail with reference to the following description and drawings, indicating the manner in which the principles of the present invention may be employed. It should be understood that the embodiments of the present invention are not limited in scope thereby. Within the spirit and scope of the appended claims, the embodiments of the present invention include many variations, modifications, and equivalents.

Features described and/or illustrated with respect to one embodiment may be used in the same or similar manner in one or more other embodiments, combined with features in other embodiments, or substituted for features in other embodiments.

It should be emphasized that the terms "comprising" or "including" when used herein refer to the presence of a feature, element, step, or component, but do not preclude the presence or addition of one or more other features, elements, steps, or components.

### BRIEF DESCRIPTION OF THE DRAWINGS

To more clearly illustrate the technical solutions in the embodiments of the present application, the drawings required for the description of the embodiments are briefly introduced below. It is apparent that the drawings described below are merely some embodiments of the present application, and those skilled in the art can obtain other drawings based on these drawings without creative effort.
FIG. 1 is a process flow diagram illustrating a manufacturing method of an encapsulation structure according to a first embodiment of the present invention.
FIGS. 2A-2J are schematic views illustrating manufacturing steps of the manufacturing method of the encapsulation structure according to the first embodiment of the present invention.
FIG. 3 is a schematic plan view of a first semiconductor chip according to an embodiment of the present invention.
FIG. 4 is a schematic view of a chip-level encapsulation structure according to the first embodiment of the present invention.
FIG. 5 is a schematic view of the connection between the chip-level encapsulation structure and an encapsulation substrate according to the first embodiment of the present invention.
FIG. 6 is a process flow diagram illustrating the manufacturing method of the encapsulation structure according to a second embodiment of the present invention.
FIGS. 7A-7J are schematic views illustrating manufacturing steps of the manufacturing method of the encapsulation structure according to the second embodiment of the present invention.
FIG. 8 is a schematic view of the chip-level encapsulation structure according to the second embodiment of the present invention.
FIG. 9 is a schematic view of the connection between the chip-level encapsulation structure and the encapsulation substrate according to the second embodiment of the present invention.
FIG. 10 is a process flow diagram illustrating the manufacturing method of the encapsulation structure according to a third embodiment of the present invention.
FIGS. 11A-11E are schematic views illustrating manufacturing steps of the manufacturing method of the encapsulation structure according to the third embodiment of the present invention.
FIG. 12 is a schematic view of the chip-level encapsulation structure according to the third embodiment of the present invention.
FIG. 13 is a schematic view illustrating the connection between the chip-level encapsulation structure and the encapsulation substrate according to the third embodiment of the present invention.

### DETAILED DESCRIPTION

The above description is merely an overview of the technical solutions of the present invention. To provide a clearer understanding of the technical means of the present invention and enable implementation in accordance with the contents of the specification, and to make the above and other objectives, features, and advantages of the present invention more apparent, preferred embodiments are provided below with reference to the accompanying drawings, as described in detail.

In the description of the present invention, it should be noted that, unless otherwise expressly specified and defined, the terms "mounted," "connected," and "coupled" should be interpreted broadly. For example, they may refer to fixed connections, detachable connections, or integral connections; mechanical connections, electrical connections, or connections capable of mutual communication; direct connections, indirect connections via an intermediary, or internal communication or interaction between two elements. The term "chip" as used herein may include a bare chip. The sequence of steps illustrated in the drawings represents an exemplary approach, but does not limit the order of execution. Those skilled in the art can understand the specific meanings of the above terms in the context of the present invention based on specific circumstances.

To make the objectives, features, and advantages of the present invention more apparent and understandable, the present invention is further described in detail below with reference to the accompanying drawings and specific embodiments.

### First Embodiment

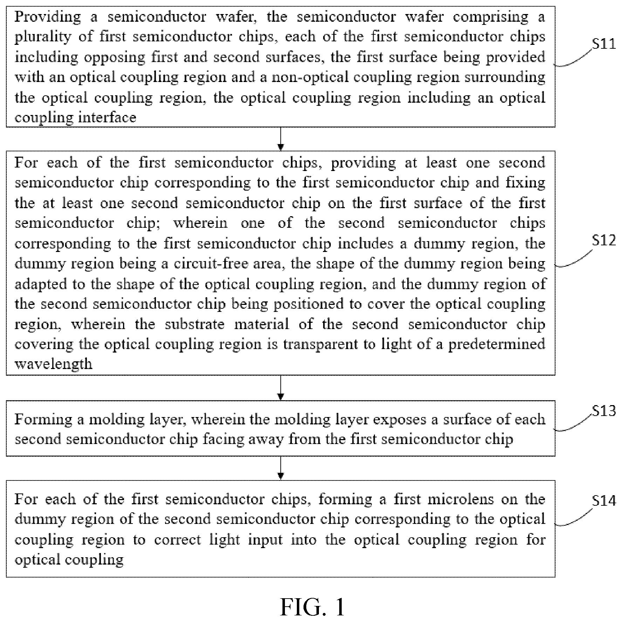

FIG. 1 is a process flow diagram illustrating a manufacturing method of an encapsulation structure according to the first embodiment of the present invention. The manufacturing method of the encapsulation structure includes:
S11: Providing a semiconductor wafer, the semiconductor wafer comprising a plurality of first semiconductor chips, each of the first semiconductor chips including opposing first and second surfaces, the first surface being provided with an optical coupling region and a non-optical coupling region surrounding the optical coupling region, the optical coupling region including an optical coupling interface;
S12: For each of the first semiconductor chips, providing at least one second semiconductor chip corresponding to the first semiconductor chip and fixing the at least one second semiconductor chip on the first surface of the first semiconductor chip; wherein one of the second semiconductor chips corresponding to the first semiconductor chip includes a dummy region, the dummy region being a circuit-free area, the shape of the dummy region being adapted to the shape of the optical coupling region, and the dummy region of the second semiconductor chip being positioned to cover the optical coupling region, wherein the substrate material of the second semiconductor chip covering the optical coupling region is transparent to light of a predetermined wavelength;
S13: Forming a molding layer, wherein the molding layer exposes a surface of each second semiconductor chip facing away from the first semiconductor chip;
S14: For each of the first semiconductor chips, forming a first microlens on the dummy region of the second semiconductor chip corresponding to the optical coupling region to correct light input into the optical coupling region for optical coupling.

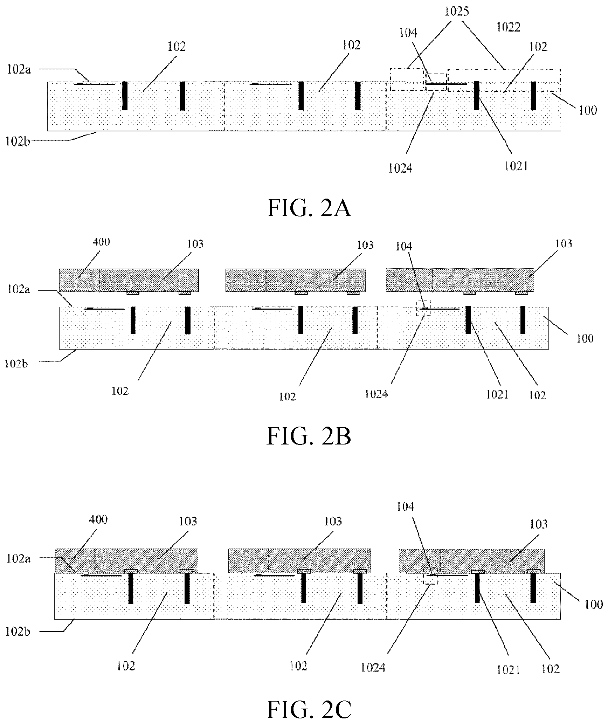

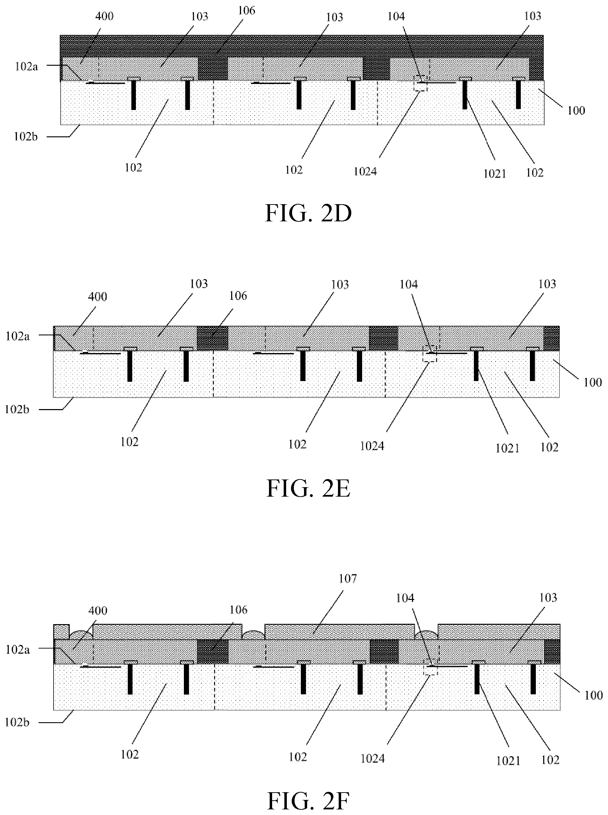

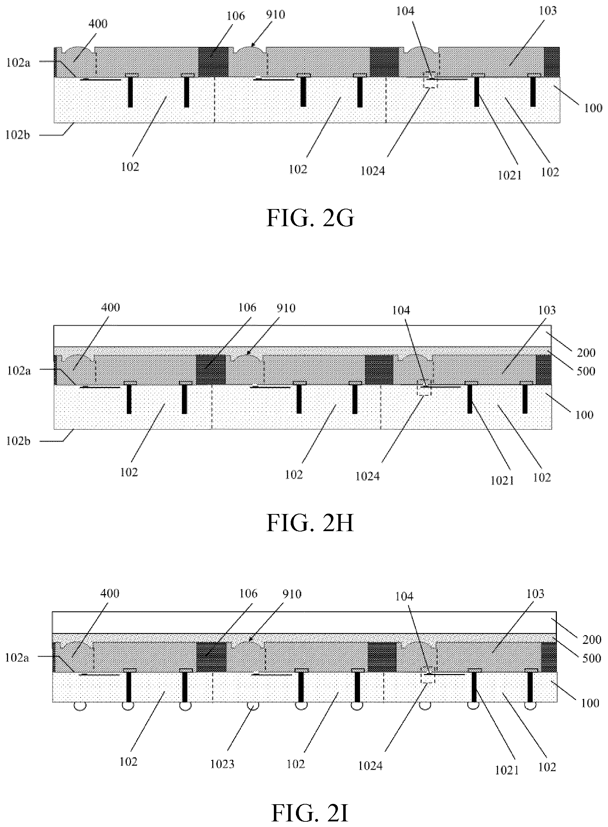

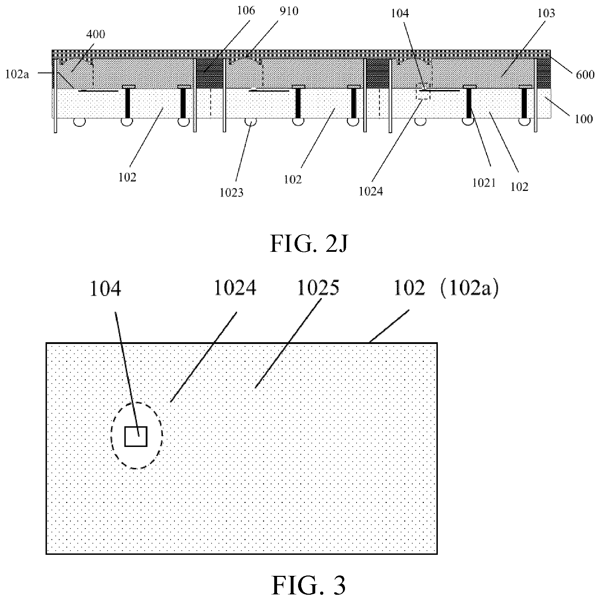

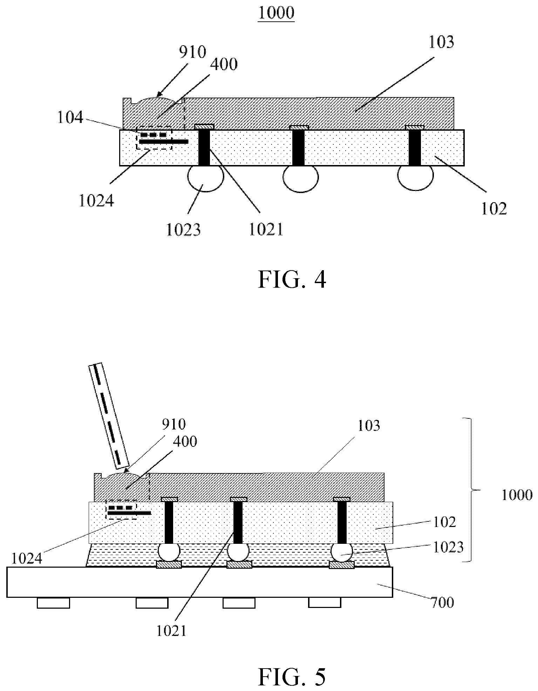

FIGS. 2A-2J are schematic views illustrating manufacturing steps of the manufacturing method of the encapsulation structure according to the first embodiment of the present invention. FIG. 3 is a schematic plan view of a first semiconductor chip according to an embodiment of the present invention. FIG. 4 is a schematic view of a chip-level encapsulation structure according to the first embodiment of the present invention.

The embodiments of the present invention are described in detail below with reference to FIGS. 2A-2J, FIG. 3, and FIG. 4.

In the embodiments of the present invention, illustratively, the first semiconductor chip 102 is a photonic integrated circuit chip (PIC chip), where the photonic integrated circuit chip processes and transmits information using photons as the information carrier, and may be, for example, a silicon-based photonic integrated circuit chip. The second semiconductor chip 103 is an electronic integrated circuit chip (EIC chip), where the electronic integrated circuit chip processes and transmits information using electrons as the information carrier, such as a silicon-based electronic integrated circuit chip, a germanium-based electronic integrated circuit chip, or a compound semiconductor electronic integrated circuit chip. By stacking the first semiconductor chip 102 and the second semiconductor chip 103, integration of the photonic integrated circuit chip and the electronic integrated circuit chip can be achieved.

Illustratively, as shown in FIG. 2A, a semiconductor wafer 100 is first provided, the semiconductor wafer 100 comprising a plurality of first semiconductor chips 102, each of the first semiconductor chips 102 including a first surface 102a and a second surface 102b that are arranged opposite each other.

As shown in FIG. 3, illustratively, the first surface 102a of the first semiconductor chip 102 is provided with an optical coupling region 1024 and a non-optical coupling region 1025 surrounding the optical coupling region 1024, the optical coupling region 1024 including an optical coupling interface 104, through which light from an external light source can be input into the optical coupling interface 104 via an optical fiber structure. For example, light is coupled by a grating coupler within the optical coupling interface 104 into the first semiconductor chip 102. It should be noted that, in other embodiments, other optical interconnection interfaces or devices for transmitting optical signals may also be provided within the optical coupling interface 104.

As shown in FIGS. 2B to 2C, for each first semiconductor chip 102, at least one second semiconductor chip 103 corresponding to the first semiconductor chip 102 is provided and fixed on the first surface 102a of the first semiconductor chip 102, wherein one second semiconductor chip 103 corresponding to the first semiconductor chip 102 includes a dummy region 400, the dummy region 400 being a circuit-free area, the shape of the dummy region 400 being adapted to the shape of the optical coupling region 1024, and the dummy region 400 of the second semiconductor chip 103 being positioned to cover the optical coupling region 1024, wherein the material of the second semiconductor chip 103 covering the optical coupling region 1024 is transparent to light of a predetermined wavelength.

In this embodiment, since the material of each second semiconductor chip 103 covering the optical coupling region 1024 needs to be transparent to light of a predetermined wavelength, silicon may be selected as the material for each second semiconductor chip 103 covering the optical coupling region 1024, i.e., the second semiconductor chip 103 is a silicon-based electronic integrated circuit chip. In practice, high-purity silicon typically achieves a transmittance of 95% or higher in the wavelength range of 1 to 7 micrometers. Since optical computing and optical communication typically use wavelength bands of 1260 nm to 1360 nm or 1530 nm to 1565 nm, the transmittance of the silicon-based second semiconductor chip 103 is extremely high.

Illustratively, as shown in FIGS. 2D to 2E, after at least one second semiconductor chip 103 is stacked on the corresponding first semiconductor chip 102, a molding layer 106 is formed to enhance the overall encapsulation strength. For each first semiconductor chip 102, the molding layer 106 encapsulates the at least one second semiconductor chip 103 and covers the remaining first surface 102a, exposing a surface of each second semiconductor chip 103 facing away from the first semiconductor chip 102.

Further, as shown in FIGS. 2F to 2G, for each first semiconductor chip 102, a first microlens 910 is formed on the dummy region 400 of the second semiconductor chip 103 corresponding to the optical coupling region 1024 to correct light input into the optical coupling region 1024 for optical coupling.

Further, the curvature of the first microlens 910 and the distance between the first microlens 910 and the optical coupling interface 104 are adjusted to focus light incident on the first microlens 910 onto the optical coupling interface 104.

In this embodiment, the first microlens 910 can focus light incident on the first microlens 910 onto the optical coupling interface 104, i.e., it can correct and focus light incident on the first microlens 910 from various directions for optical coupling onto the optical coupling interface 104. This significantly reduces the requirements for subsequent optical coupling precision and improves the efficiency of the surface coupling process. Additionally, the position, curvature, and other parameters of the first microlens 910 can be pre-calculated based on optical path design requirements to ensure that light incident on the first microlens 910 is ultimately focused onto the optical coupling interface 104 within the corresponding optical coupling region 1024. Compared to conventional techniques that require die attach equipment to achieve a placement accuracy of ±2.5 µm in the X-Y direction to control the coupling loss of the grating coupler within 1 dB, the technical solution provided by embodiments of the present invention can expand the alignment tolerance between the optical fiber structure and the optical coupling interface 104 to ±7 µm to ±9 µm, making it easier for commonly used die attach equipment to meet the above placement accuracy requirements.

Specifically, as shown in FIGS. 2F to 2G, the method of forming the first microlens on the dummy region of the second semiconductor chip corresponding to the optical coupling region for each first semiconductor chip includes:

Step S101: Forming a photoresist layer 107 on the exposed surface of each second semiconductor chip 103, wherein the material of the photoresist layer 107 includes photoresist.

Step S102: Performing patterned photolithography on the photoresist layer 107 using a mask process to form an arc-shaped protrusion structure corresponding to the optical coupling region 1024 in the remaining photoresist layer 107; illustratively, for example, using a mask with gradient grayscale to perform patterned exposure on the photoresist layer 107 to cure a portion of the photoresist layer 107 and remove the uncured portion, thereby forming a corresponding arc-shaped protrusion structure in a portion of the photoresist layer 107 (e.g., the protrusion topography formed by the photoresist layer 107 as shown in FIG. 2F), and using the portion of the photoresist layer 107 covering the remaining surface of the second semiconductor chip 103 as an etching protection layer.

Step S103: Etching the arc-shaped protrusion structure using an etching process to form the first microlens 910 on each second semiconductor chip 103 corresponding to the optical coupling region 1024. Specifically, when the first microlens 910 is successfully transferred to the dummy region 400 of the corresponding second semiconductor chip 103 using photolithography and etching techniques, the portion of the photoresist layer 107 covering the remaining surface of the second semiconductor chip 103 is removed to expose the surface of each second semiconductor chip 103 facing away from the first semiconductor chip 102.

Optionally, continuing to refer to FIG. 2A, the method further includes: before fixing the at least one second semiconductor chip 103 on the first surface 102a of the first semiconductor chip 102, forming a plurality of metal connection pillars 1021 in each first semiconductor chip 102, wherein one side surface of each metal connection pillar 1021 is exposed from the surface of the first semiconductor chip 102.

It should be noted that since the first microlens 910 is formed on a second semiconductor chip 103 located above the optical coupling region 1024, in the optical path design, to minimize the vertical gap between the second semiconductor chip 103 with the first microlens 910 and the optical coupling interface 104, and to avoid unnecessary optical path loss due to light passing through excessive medium layers causing deviation in the optical path propagation direction, preferably, as shown in FIG. 2C, the at least one second semiconductor chip 103 is fixed on the first surface 102a of the corresponding first semiconductor chip 102 using hybrid bonding, wherein the surface of the at least one second semiconductor chip 103 is directly and closely connected to the surface of the corresponding first semiconductor chip 102 via intermolecular van der Waals forces.

Further, as shown in FIGS. 2H to 2I, the method further includes: after forming the first microlens 910 on the dummy region 400 of the second semiconductor chip 103 corresponding to the optical coupling region 1024 for each first semiconductor chip 102, temporarily bonding the surface of each second semiconductor chip 103 facing away from the first semiconductor chip 102 to a first carrier substrate 200 using a temporary bonding adhesive 500; then, thinning the body of the first semiconductor chip 102 on the side away from the at least one second semiconductor chip 103 to expose the surface of the metal connection pillars 1021 facing away from the at least one second semiconductor chip 103; and after exposing the surface of the metal connection pillars 1021, forming a first conductive bump 1023 on the exposed surface of each metal connection pillar 1021.

As shown in FIGS. 2I to 2J, after forming the first conductive bump 1023 on the exposed surface of each metal connection pillar 1021, debonding the first carrier substrate 200; attaching the surface of each second semiconductor chip 103 facing away from the first semiconductor chip 102 to a dicing tape 600; and dicing at the position of dicing streets between adjacent first semiconductor chips 102 to obtain a plurality of separated chip encapsulation assemblies, wherein each chip encapsulation assembly includes one first semiconductor chip and at least one corresponding second semiconductor chip.

It should be understood that, in this embodiment, the dicing tape 600 can be used to buffer the cutting stress on the at least one second semiconductor chip 103 during dicing and can protect the first microlens 910 from being scratched during the dicing process.

Specifically, as shown in FIG. 4, each chip encapsulation assembly 1000 includes one first semiconductor chip 102 and at least one corresponding second semiconductor chip 103. It should be understood that the embodiment shown in FIG. 4 illustrates only one second semiconductor chip 103 formed above the first semiconductor chip 102. In actual use, there may be more than one second semiconductor chip 103, such as 2, 3, 4, or more, which can be flexibly selected based on actual needs.

FIG. 5 is a schematic view illustrating the connection between a chip-level encapsulation structure and an encapsulation substrate according to the first embodiment of the present invention.

As shown in FIG. 5, the manufacturing method of the encapsulation structure further includes: after obtaining a plurality of separated chip encapsulation assemblies 1000, mounting each chip encapsulation assembly 1000 onto a corresponding encapsulation substrate 700. Specifically, the chip encapsulation assembly 1000 includes at least one first conductive bump 1023, wherein each first conductive bump 1023 is bonded to an electrical connection point (not labeled) on the encapsulation substrate 700. Additional discrete components such as capacitors, resistors, or inductors may also be mounted or integrated on the encapsulation substrate 700 as needed.

Further, after bonding the chip encapsulation assembly 1000 having at least one first conductive bump 1023 to the electrical connection points on the encapsulation substrate 700, an optical fiber structure is mounted onto the first microlens 910, such that light provided by an external light source is incident on the corresponding first microlens 910 via the optical fiber structure and is then focused and incident on the corresponding optical coupling interface 104.

According to another aspect of the present invention, an encapsulation structure is provided.

Specifically, as shown in FIG. 4, the encapsulation structure includes:
a first semiconductor chip 102 including a first surface and a second surface that are opposite each other, the first surface being provided with an optical coupling region 1024 and a non-optical coupling region 1025 surrounding the optical coupling region 1024, the optical coupling region 1024 including an optical coupling interface 104;
at least one second semiconductor chip 103 fixed on the first surface, wherein one second semiconductor chip 103 corresponding to the first semiconductor chip 102 includes a dummy region 400, the dummy region 400 being a circuit-free area, the shape of the dummy region 400 being adapted to the shape of the optical coupling region 1024 and covering the optical coupling region 1024, and the material of the second semiconductor chip 103 covering the optical coupling region 1024 is transparent to light of a predetermined wavelength; and
a first microlens 910 formed on the dummy region 400 of the second semiconductor chip 103 corresponding to the optical coupling region 1024.

Optionally, in some embodiments, the encapsulation structure further includes a molding layer located on the first surface of the first semiconductor chip and encapsulating a side surface of the at least one second semiconductor chip.

Illustratively, the curvature of the first microlens 910 and the distance between the first microlens 910 and the optical coupling interface 104 are adjusted to focus light incident on the first microlens 910 onto the optical coupling interface 104.

Specifically, for each second semiconductor chip 103 covering the optical coupling region 1024, the material of the second semiconductor chip 103 includes silicon. This is because high-purity silicon typically achieves a transmittance of 95% or higher in the wavelength range of 1 to 7 micrometers, and optical computing and optical communication typically use wavelength bands of 1260 nm to 1360 nm or 1530 nm to 1565 nm, making the transmittance of the silicon-based second semiconductor chip 103 extremely high.

Further, a plurality of metal connection pillars 1021 are provided in each first semiconductor chip 102, and one side surface of each metal connection pillar 1021 is exposed from the surface of the first semiconductor chip 102.

Further, as shown in FIG. 5, each metal connection pillar 1021 is electrically connected to a corresponding encapsulation substrate 700 via a first conductive bump 1023; the encapsulation structure further includes an optical fiber structure mounted on a surface of the first microlens 910 facing away from the corresponding first semiconductor chip 102.

### Second Embodiment

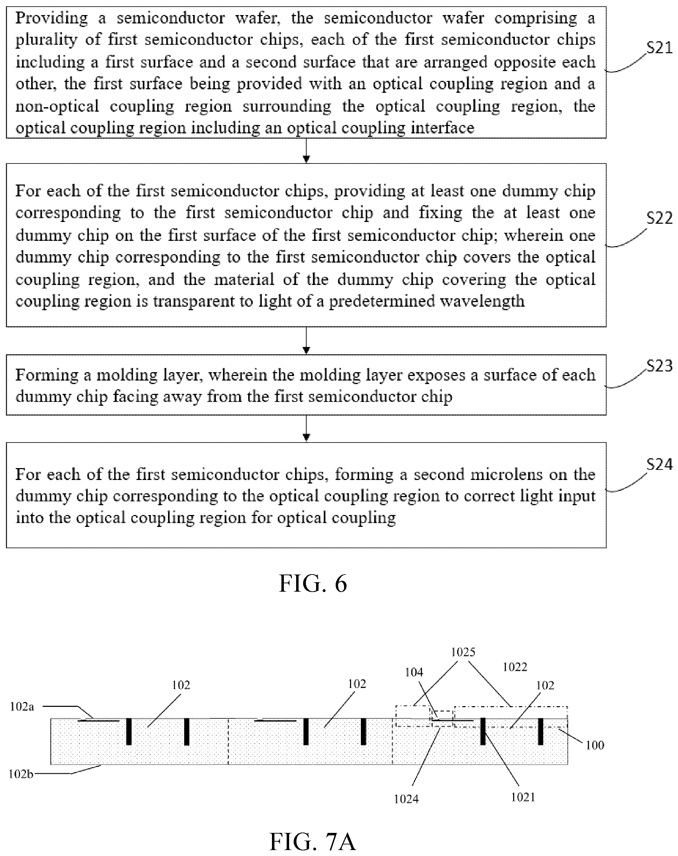

FIG. 6 is a process flow diagram illustrating a manufacturing method of an encapsulation structure according to the second embodiment of the present invention. The manufacturing method of the encapsulation structure includes:
S21: Providing a semiconductor wafer, the semiconductor wafer comprising a plurality of first semiconductor chips, each of the first semiconductor chips including a first surface and a second surface that are arranged opposite each other, the first surface being provided with an optical coupling region and a non-optical coupling region surrounding the optical coupling region, the optical coupling region including an optical coupling interface;
S22: For each of the first semiconductor chips, providing at least one dummy chip corresponding to the first semiconductor chip and fixing the at least one dummy chip on the first surface of the first semiconductor chip; wherein one dummy chip corresponding to the first semiconductor chip covers the optical coupling region, and the material of the dummy chip covering the optical coupling region is transparent to light of a predetermined wavelength;
S23: Forming a molding layer, wherein the molding layer exposes a surface of each dummy chip facing away from the first semiconductor chip;
S24: For each of the first semiconductor chips, forming a second microlens on the dummy chip corresponding to the optical coupling region to correct light input into the optical coupling region for optical coupling.

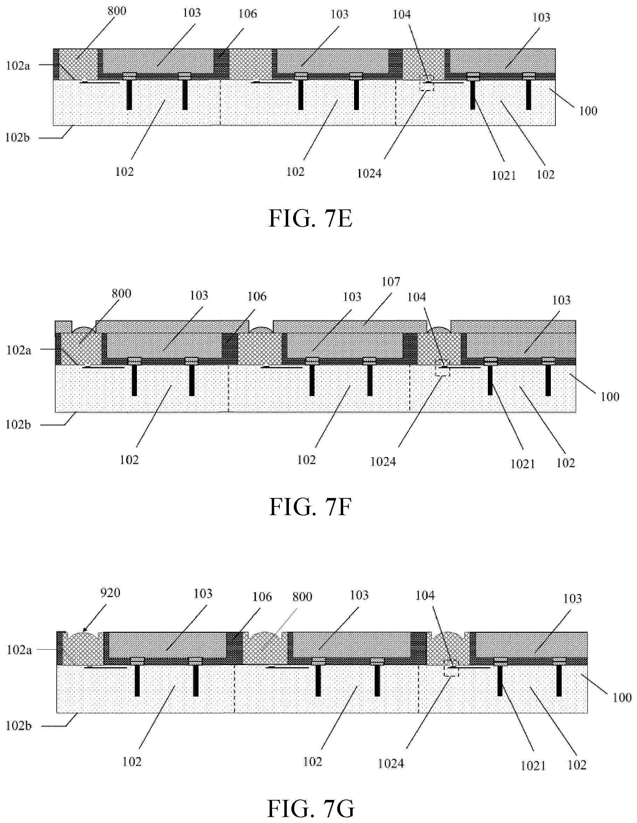

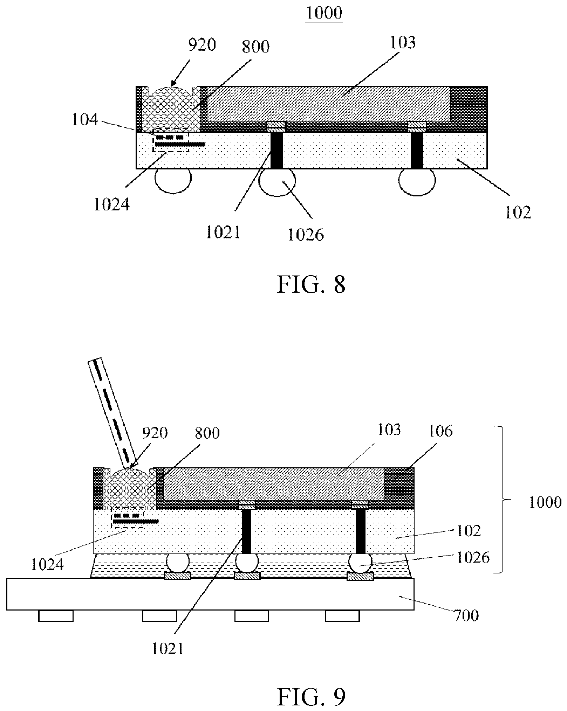

FIGS. 7A to 7J are schematic views illustrating manufacturing steps of the manufacturing method of the encapsulation structure according to the second embodiment of the present invention. FIG. 8 is a schematic view of a chip-level encapsulation structure according to the second embodiment of the present invention.

The embodiments of the present invention are described in detail below with reference to FIGS. 7A to 7J and FIG. 8.

The difference from the manufacturing method provided in the first embodiment is that this embodiment provides a method of forming a second microlens 920 on a dummy chip 800 (a wafer that does not integrate or include any photonic or electronic devices) covering the optical coupling region 1024 to correct light input into the optical coupling region 1024 for optical coupling.

In this embodiment, since the material of each dummy chip 800 covering the optical coupling region 1024 needs to be transparent to light of a predetermined wavelength, high-purity silicon or glass may be selected as the material for each dummy chip 800 covering the optical coupling region 1024, i.e., the dummy chip 800 is a silicon-based dummy chip or a glass-based dummy chip.

Illustratively, in this embodiment, as shown in FIG. 7A, a semiconductor wafer 100 is first provided, the semiconductor wafer 100 comprising a plurality of first semiconductor chips 102, each of the first semiconductor chips 102 including a first surface 102a and a second surface 102b that are arranged opposite each other.

Continuing to refer to FIG. 3, in an exemplary manner, the first surface 102a of the first semiconductor chip 102 is provided with an optical coupling region 1024 and a non-optical coupling region 1025 surrounding the optical coupling region 1024, the optical coupling region 1024 including an optical coupling interface 104, through which light from an external light source can be input into the optical coupling interface 104 via an optical fiber structure. For example, light is coupled by a grating coupler within the optical coupling interface 104 into the first semiconductor chip 102. It should be noted that, in other embodiments, other optical interconnection interfaces or devices for transmitting optical signals may also be provided within the optical coupling interface 104.

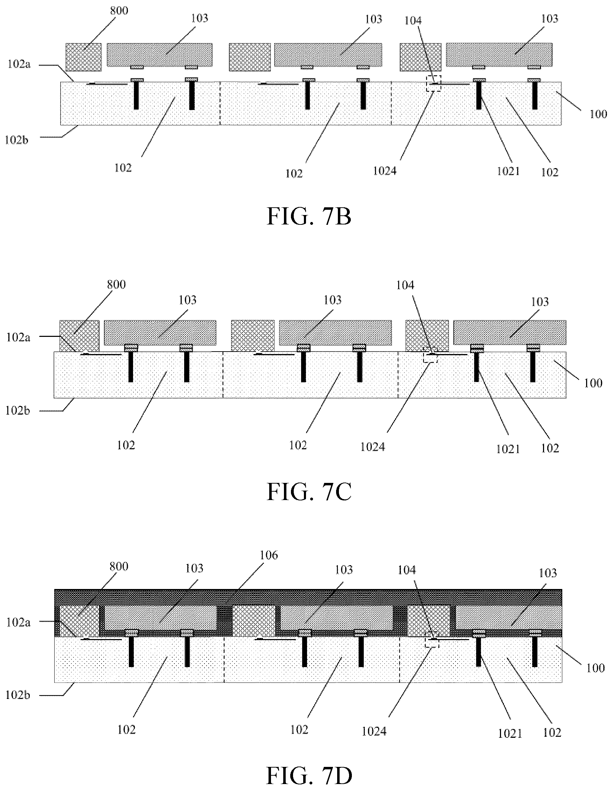

As shown in FIGS. 7B to 7C, in some embodiments, the manufacturing method of the encapsulation structure further includes: for each first semiconductor chip 102, providing at least one second semiconductor chip 103 corresponding to the first semiconductor chip 102 and fixing the at least one second semiconductor chip 103 on the non-optical coupling region 1025 of the first surface 102a of the first semiconductor chip 102.

Illustratively, in some embodiments, after at least one dummy chip 800 is stacked on the corresponding first semiconductor chip 102, a molding layer 106 is formed to enhance the overall encapsulation strength. For each first semiconductor chip 102, the molding layer 106 encapsulates the at least one dummy chip 800 and covers the remaining first surface 102a, exposing a surface of each dummy chip 800 facing away from the first semiconductor chip 102.

Illustratively, in other embodiments, as shown in FIG. 7D, after at least one dummy chip 800 and at least one second semiconductor chip 103 are stacked on the corresponding first semiconductor chip 102, a molding layer 106 is formed to enhance the overall encapsulation strength. For each first semiconductor chip 102, the molding layer 106 encapsulates the side surfaces of the at least one dummy chip 800 and the at least one second semiconductor chip 103 and covers the remaining first surface 102a, as shown in FIG. 7E, exposing a surface of each dummy chip 800 and each second semiconductor chip 103 facing away from the first semiconductor chip 102.

Further, as shown in FIGS. 7C to 7E, in a direction perpendicular to the first surface 102a of the corresponding first semiconductor chip 102, a top surface of the at least one dummy chip 800 facing away from the first surface 102a is flush with a top surface of the at least one second semiconductor chip 103 facing away from the first surface 102a. That is, the encapsulated at least one second semiconductor chip 103 and at least one dummy chip 800 have the same height, resulting in a flat, robust, and highly reliable surface for the 3D chip stacked encapsulation structure. Additionally, after thinning the molding layer 106, a relatively flat molding surface can also be obtained for forming the second microlens 920.

Specifically, as shown in FIGS. 7F to 7G, the method of forming the second microlens on the dummy chip corresponding to the optical coupling region for each first semiconductor chip includes:
Step S201: Forming a photoresist layer 107 on the exposed surface of each dummy chip 800, wherein the material of the photoresist layer 107 includes photoresist.

Step S202: Performing patterned photolithography on the photoresist layer 107 using a mask process to form an arc-shaped protrusion structure corresponding to the optical coupling region 1024 in the remaining photoresist layer 107; illustratively, for example, using a mask with gradient grayscale to perform patterned exposure on the photoresist layer 107 to cure a portion of the photoresist layer 107 and remove the uncured portion, thereby forming a corresponding arc-shaped protrusion structure in a portion of the photoresist layer 107 (e.g., the protrusion topography formed by the photoresist layer 107 as shown in FIG. 7F), and using the portion of the photoresist layer 107 covering the remaining surface of the dummy chip 800 as an etching protection layer.

Step S203: Etching the arc-shaped protrusion structure using an etching process to form the second microlens 920 on each dummy chip 800 corresponding to the optical coupling region 1024. Specifically, when the second microlens 920 is successfully transferred to the corresponding dummy chip 800 using photolithography and etching techniques, the portion of the photoresist layer 107 covering the remaining surface of the dummy chip 800 is removed to expose the surface of each dummy chip 800 facing away from the first semiconductor chip 102.

Optionally, continuing to refer to FIG. 7A, in some embodiments, the method further includes: before fixing the at least one second semiconductor chip 103 on the first surface 102a of the first semiconductor chip 102, forming a plurality of metal connection pillars 1021 in each first semiconductor chip 102, wherein one side surface of each metal connection pillar 1021 is exposed from the surface of the first semiconductor chip 102.

Further, continuing to refer to FIGS. 7B to 7C, fixing the at least one second semiconductor chip and the at least one dummy chip on the first semiconductor chip includes: fixing the at least one second semiconductor chip 103 on the first surface 102a of the first semiconductor chip 102 using thermal compression bonding (TCB), reflow soldering, or hybrid bonding. Illustratively, in this embodiment, the second semiconductor chip 103 is bonded to the first semiconductor chip 102 using flip-chip bonding. Optionally, an underfill is applied in the gap between each second semiconductor chip 103 and the first surface 102a to further reinforce each second semiconductor chip 103.

It should be noted that since the second microlens 920 is formed on a dummy chip 800 located above the optical coupling region 1024, in the optical path design, to minimize the vertical gap between the dummy chip 800 with the second microlens 920 and the optical coupling interface 104, and to avoid unnecessary optical path loss due to light passing through excessive medium layers causing deviation in the optical path propagation direction, preferably, as shown in FIG. 7C, each dummy chip 800 is fixed on the first surface 102a of the corresponding first semiconductor chip 102 using hybrid bonding, wherein the surface of each dummy chip 800 is directly and closely connected to the surface of the corresponding first semiconductor chip 102 via intermolecular van der Waals forces.

In a direction perpendicular to the first surface of the corresponding first semiconductor chip 102, a top surface of the at least one dummy chip 800 facing away from the first surface is flush with a top surface of the at least one second semiconductor chip 103 facing away from the first surface, resulting in a flat, robust, and highly reliable surface for the 3D chip stacked encapsulation structure.

As shown in FIG. 7D, the molding layer 106 is formed, the molding layer 106 encapsulating the side surfaces of each second semiconductor chip 103 and each dummy chip 800.

As shown in FIG. 7E, the molding layer 106 is polished to expose the surface of each second semiconductor chip 103 facing away from the first semiconductor chip 102 and the surface of each dummy chip 800 facing away from the first semiconductor chip 102.

As shown in FIGS. 7F to 7G, the method of forming the second microlens on the dummy chip corresponding to the optical coupling region for each first semiconductor chip includes:
Step S201: Forming a photoresist layer 107 on the exposed surface of each second semiconductor chip 103 and each dummy chip 800, wherein the material of the photoresist layer 107 includes photoresist.

Step S202: Performing patterned photolithography on the photoresist layer 107 using a mask process to form an arc-shaped protrusion structure corresponding to the optical coupling region 1024 in the remaining photoresist layer 107; illustratively, for example, using a mask with gradient grayscale to perform patterned exposure on the photoresist layer 107 to cure a portion of the photoresist layer 107 and remove the uncured portion, thereby forming a corresponding arc-shaped protrusion structure in a portion of the photoresist layer 107 (e.g., the protrusion topography formed by the photoresist layer 107 as shown in FIG. 7F).

Step S203: Etching the arc-shaped protrusion structure using an etching process to form the second microlens 920 on each second semiconductor chip 103 corresponding to the optical coupling region 1024. Specifically, when the second microlens 920 is successfully transferred to the corresponding dummy chip 800 using photolithography and etching techniques, the portion of the photoresist layer 107 covering the remaining surface of the second semiconductor chip 103 and the dummy chip is removed to expose the surface of each dummy chip 800 facing away from the first semiconductor chip 102 and the surface of each second semiconductor chip 103 facing away from the first semiconductor chip 102.

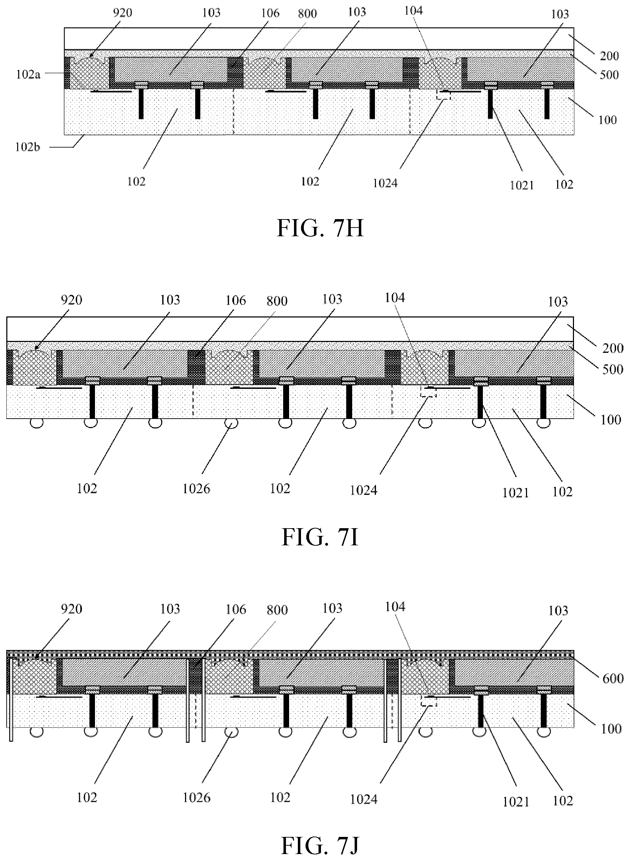

Further, as shown in FIG. 7H, the method further includes: after forming the second microlens 920 on the dummy chip 800 corresponding to the optical coupling region 1024 for each first semiconductor chip 102, temporarily bonding the surface of each dummy chip 800 facing away from the first semiconductor chip 102 to a first carrier substrate 200 using a temporary bonding adhesive 500; then, as shown in FIG. 7I, thinning the body of the first semiconductor chip 102 on the side away from the at least one dummy chip 800 to expose the surface of the metal connection pillars 1021 facing away from the at least one dummy chip 800; and after exposing the surface of the metal connection pillars 1021, forming a second conductive bump 1026 on the exposed surface of each metal connection pillar 1021.

As shown in FIG. 7J, after the second conductive bump 1026 is formed on the exposed surface of each metal connection pillar 1021, the first carrier substrate 200 is debonded; the surface of each dummy chip 800 facing away from the first semiconductor chip 102 is attached to a dicing tape 600; and dicing is performed at the position of dicing streets between adjacent first semiconductor chips 102 to obtain a plurality of separated chip encapsulation assemblies, wherein, in some embodiments, each chip encapsulation assembly includes one first semiconductor chip and at least one corresponding dummy chip. In other embodiments, each chip encapsulation assembly includes one first semiconductor chip, at least one corresponding dummy chip, and at least one corresponding second semiconductor chip.

It should be understood that, in this embodiment, the dicing tape 600 can be used to buffer the cutting stress on the at least one dummy chip 800 during dicing and can protect the second microlens 920 from being scratched during the dicing process.

Specifically, as shown in FIG. 8, each chip encapsulation assembly 1000 includes one first semiconductor chip 102, at least one corresponding dummy chip 800, and at least one second semiconductor chip 103. It should be understood that the embodiment shown in FIG. 8 illustrates only one second semiconductor chip 103 formed above the first semiconductor chip 102. In actual use, there may be more than one second semiconductor chip 103, such as 2, 3, 4, or more, which can be flexibly selected based on actual needs.

FIG. 9 is a schematic view of the connection between a chip-level encapsulation structure and an encapsulation substrate according to the second embodiment of the present invention.

As shown in FIG. 9, the manufacturing method of the encapsulation structure further includes: after a plurality of separated chip encapsulation assemblies 1000 are obtained, each chip encapsulation assembly 1000 is mounted onto a corresponding encapsulation substrate 700. Specifically, the chip encapsulation assembly 1000 includes at least one second conductive bump 1026, and each second conductive bump 1026 is bonded to an electrical connection point (not labeled) on the encapsulation substrate 700. Additional discrete components such as capacitors, resistors, or inductors may also be mounted or integrated on the encapsulation substrate 700 as needed.

Further, after the chip encapsulation assembly 1000 including at least one second conductive bump 1026 is bonded to the electrical connection points on the encapsulation substrate 700, an optical fiber structure is mounted onto the second microlens 920, such that light provided by an external light source is incident on the corresponding second microlens 920 via the optical fiber structure and is then focused and incident on the corresponding optical coupling interface 104.

According to another aspect of the present invention, an encapsulation structure is provided.

Specifically, as shown in FIG. 8, the encapsulation structure includes:
a first semiconductor chip 102 including a first surface and a second surface that are arranged opposite each other, the first surface being provided with an optical coupling region 1024 and a non-optical coupling region 1025 surrounding the optical coupling region 1024, the optical coupling region 1024 including an optical coupling interface 104;
at least one dummy chip 800 fixed on the first surface, wherein one dummy chip 800 corresponding to the first semiconductor chip 102 covers the optical coupling region 1024, and the material of the dummy chip 800 covering the optical coupling region 1024 is transparent to light of a predetermined wavelength;
a molding layer 106 located on the first surface of the first semiconductor chip 102 and encapsulating the at least one dummy chip 800; and
a second microlens 920 formed on the dummy chip 800 corresponding to the optical coupling region 1024.

It should be noted that, in this embodiment, the dummy chip 800 is a wafer that does not integrate or include any photonic or electronic devices.

Optionally, in some embodiments, the encapsulation structure further includes at least one second semiconductor chip 103 fixed on the non-optical coupling region 1025 of the first surface of the first semiconductor chip 102. It should be understood that, in this embodiment, the molding layer 106 is located on the first surface of the first semiconductor chip 102 and encapsulates the side surfaces of the at least one dummy chip 800 and the at least one second semiconductor chip 103.

Further, in a direction perpendicular to the first surface of the corresponding first semiconductor chip 102, a top surface of the at least one dummy chip 800 facing away from the first surface is flush with a top surface of the at least one second semiconductor chip 103 facing away from the first surface. That is, the encapsulated at least one second semiconductor chip 103 and at least one dummy chip 800 have the same height, resulting in a flat, robust, and highly reliable surface for the 3D chip stacked encapsulation structure.

Illustratively, the curvature of the second microlens 920 and the distance between the second microlens 920 and the optical coupling interface 104 are adjusted to focus light incident on the second microlens 920 onto the optical coupling interface 104.

Specifically, in this embodiment, since the material of each dummy chip 800 covering the optical coupling region 1024 needs to be transparent to light of a predetermined wavelength, silicon or glass may be selected as the material for each dummy chip 800 covering the optical coupling region 1024, i.e., the dummy chip 800 is a silicon-based dummy chip or a glass-based dummy chip.

Further, a plurality of metal connection pillars 1021 are provided in each first semiconductor chip 102, and one side surface of each metal connection pillar 1021 is exposed from the surface of the first semiconductor chip 102.

Further, as shown in FIG. 9, each metal connection pillar 1021 is electrically connected to a corresponding encapsulation substrate 700 via a second conductive bump 1026; the encapsulation structure further includes an optical fiber structure, the optical fiber structure being mounted on a surface of the second microlens 920 facing away from the corresponding first semiconductor chip 102.

### Third Embodiment

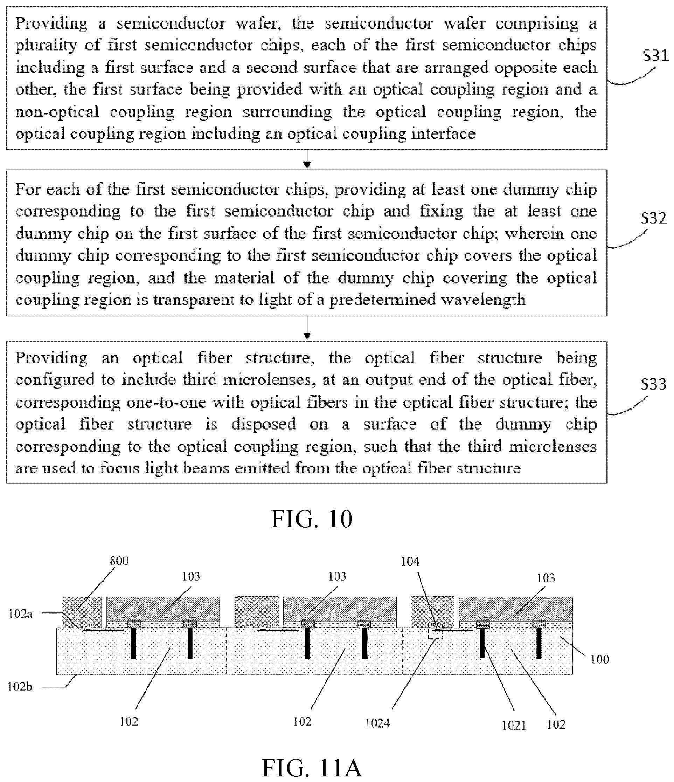

FIG. 10 is a process flow diagram illustrating the manufacturing method of the encapsulation structure according to the third embodiment of the present invention. The manufacturing method of the encapsulation structure includes:
S31: Providing a semiconductor wafer, the semiconductor wafer comprising a plurality of first semiconductor chips, each of the first semiconductor chips including a first surface and a second surface that are arranged opposite each other, the first surface being provided with an optical coupling region and a non-optical coupling region surrounding the optical coupling region, the optical coupling region including an optical coupling interface;
S32: For each of the first semiconductor chips, providing at least one dummy chip corresponding to the first semiconductor chip and fixing the at least one dummy chip on the first surface of the first semiconductor chip; wherein one dummy chip corresponding to the first semiconductor chip covers the optical coupling region, and the material of the dummy chip covering the optical coupling region is transparent to light of a predetermined wavelength;
S33: Providing an optical fiber structure, the optical fiber structure being configured to include third microlenses, at an output end of the optical fiber, corresponding one-to-one with optical fibers in the optical fiber structure; the optical fiber structure is disposed on a surface of the dummy chip corresponding to the optical coupling region, such that the third microlenses are used to focus light beams emitted from the optical fiber structure.

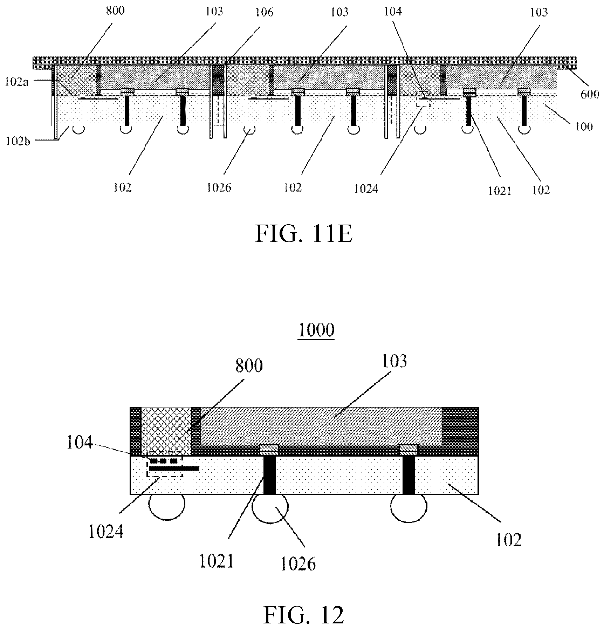

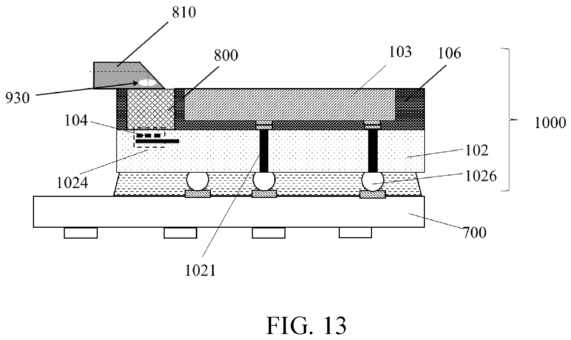

FIGS. 11A-11E are schematic views illustrating manufacturing steps of a method for manufacturing an encapsulation structure according to the third embodiment of the present invention. FIG. 12 is a schematic view of a chip-level encapsulation structure according to the third embodiment of the present invention. FIG. 13 is a schematic view illustrating the connection between a chip-level encapsulation structure and an encapsulation substrate according to the third embodiment of the present invention.

The embodiments of the present invention are described in detail below with reference to FIGS. 11A-11E, FIG. 12, and FIG. 13.

The difference from the manufacturing methods provided in the first and second embodiments is that this embodiment provides a method of disposing an optical fiber structure having third microlenses at its output end on a dummy chip covering the optical coupling region to correct light input into the optical coupling region for optical coupling.

Illustratively, in this embodiment, as shown in FIG. 11A, for each first semiconductor chip 102, at least one second semiconductor chip 103 and at least one dummy chip 800 corresponding to the first semiconductor chip 102 are provided, and the at least one second semiconductor chip 103 is fixed on the non-optical coupling region 1025 of the first surface 102a of the first semiconductor chip 102, and the at least one dummy chip 800 is fixed on the optical coupling region 1024 of the first surface 102a of the first semiconductor chip 102.

Specifically, the at least one second semiconductor chip 103 is fixed on the first surface 102a of the first semiconductor chip 102 using thermal compression bonding (TCB), reflow soldering, or hybrid bonding. Optionally, an underfill is applied in the gap between each second semiconductor chip 103 and the first surface 102a to further reinforce each second semiconductor chip 103.

Each dummy chip 800 is fixed on the first surface 102a of the corresponding first semiconductor chip 102 using hybrid bonding, wherein the surface of each dummy chip 800 is directly and closely connected to the surface of the corresponding first semiconductor chip 102 via intermolecular van der Waals forces.

Optionally, in some embodiments, before the at least one second semiconductor chip 103 is fixed on the first surface 102a of the first semiconductor chip 102, a plurality of metal connection pillars 1021 are formed in each first semiconductor chip 102, wherein one side surface of each metal connection pillar 1021 is exposed from the surface of the first semiconductor chip 102.

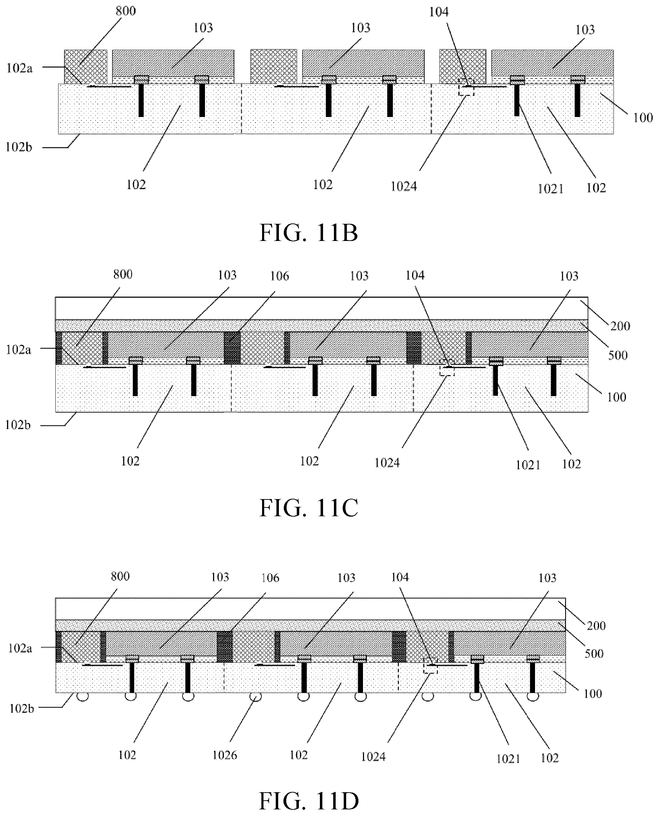

As shown in FIG. 11B, a molding layer 106 is formed, the molding layer 106 encapsulating the side surfaces of each second semiconductor chip 103 and each dummy chip 800.

As shown in FIG. 11C, the method further includes: the surface of each dummy chip 800 facing away from the first semiconductor chip 102 is temporarily bonded to a first carrier substrate 200 using a temporary bonding adhesive 500; then, as shown in FIG. 11D, the body of the first semiconductor chip 102 on the side away from the at least one dummy chip 800 is thinned to expose the surface of the metal connection pillars 1021 facing away from the at least one dummy chip 800; and after the surface of the metal connection pillars 1021 is exposed, a second conductive bump 1026 is formed on the exposed surface of each metal connection pillar 1021.

As shown in FIG. 11E, after the second conductive bump 1026 is formed on the exposed surface of each metal connection pillar 1021, the first carrier substrate 200 is debonded; the surface of each dummy chip 800 facing away from the first semiconductor chip 102 is attached to a dicing tape 600; and dicing is performed at the position of dicing streets between adjacent first semiconductor chips 102 to obtain a plurality of separated chip encapsulation assemblies, wherein, in some embodiments, each chip encapsulation assembly includes one first semiconductor chip and at least one corresponding dummy chip. In other embodiments, each chip encapsulation assembly includes one first semiconductor chip, at least one corresponding dummy chip, and at least one corresponding second semiconductor chip.

It should be understood that, in this embodiment, the dicing tape 600 can be used to buffer the cutting stress on the at least one dummy chip 800 during dicing.

Specifically, as shown in FIG. 12, each chip encapsulation assembly 1000 includes one first semiconductor chip 102, at least one corresponding dummy chip 800, and at least one second semiconductor chip 103. It should be understood that the embodiment shown in FIG. 8 illustrates only one second semiconductor chip 103 formed above the first semiconductor chip 102. In actual use, there may be more than one second semiconductor chip 103, such as 2, 3, 4, or more, which can be flexibly selected based on actual needs.

As shown in FIG. 13, after a plurality of separated chip encapsulation assemblies 1000 are obtained, each chip encapsulation assembly 1000 is mounted onto a corresponding encapsulation substrate 700. Specifically, the chip encapsulation assembly 1000 includes at least one second conductive bump 1026, each second conductive bump 1026 being bonded to an electrical connection point (not labeled) on the substrate 700. Additional discrete components such as capacitors, resistors, or inductors may also be mounted or integrated on the encapsulation substrate 700 as needed.

An optical fiber structure 810 including third microlenses is mounted on a dummy chip 800 above the corresponding optical coupling region 1024. In this embodiment, one end of the optical fiber structure 810 may have an inclined surface at a predetermined angle, such as 45°, relative to its main body; the main body of the optical fiber structure 810 is laid flat on the surface of the first substrate layer 401 facing away from the first semiconductor chip 102, such that light transmitted within the optical fiber structure 810 undergoes total reflection at the inclined surface of the end, enters the third microlens 930, and is focused by the third microlens 930 before being incident on the corresponding optical coupling interface 104 via the dummy chip 800.

In this embodiment, for each first semiconductor chip, an optical fiber structure having third microlenses at its output end is disposed on a dummy chip covering the optical coupling region to correct light input into the optical coupling region for optical coupling. Since the third microlenses can focus light emitted from the optical fiber structure and transmit it through the dummy chip to the optical coupling interface, the requirements for subsequent optical coupling precision are significantly reduced, the efficiency of the surface coupling process is improved, and the tolerance for placement alignment errors of die attach equipment is increased. Additionally, the material of the dummy chip covering the optical coupling region has high transparency to light of a predetermined wavelength, resulting in minimal loss of light after passing through the dummy chip. Furthermore, the thickness of the dummy chip provides support for the optical fiber structure, significantly reducing stress on the first semiconductor chip and enhancing the stability of the encapsulation structure.

According to another aspect of the present invention, an encapsulation structure is provided.

Specifically, as shown in FIGS. 12 and 13, the encapsulation structure includes:
a first semiconductor chip 102 including opposing first and second surfaces, the first surface being provided with an optical coupling region 1024 and a non-optical coupling region 1025 surrounding the optical coupling region 1024, the optical coupling region 1024 including an optical coupling interface 104;
at least one dummy chip 800 fixed on the first surface, wherein one dummy chip 800 corresponding to the first semiconductor chip 102 covers the optical coupling region 1024, and the material of the dummy chip 800 covering the optical coupling region 1024 is transparent to light of a predetermined wavelength;
an optical fiber structure 810 disposed on the dummy chip 800 corresponding to the optical coupling region 1024, wherein an output end of the optical fiber structure 810 is provided with third microlenses 930 corresponding one-to-one with optical fibers in the optical fiber structure 810, configured to focus light emitted from the optical fiber structure onto the optical coupling interface.

Further, the encapsulation structure further includes a molding layer 106 located on the first surface of the first semiconductor chip 102 and encapsulating a side surface of the at least one dummy chip 800.

Further, the encapsulation structure further includes at least one second semiconductor chip 103 fixed on the non-optical coupling region 1025 of the first surface of the first semiconductor chip 102.

Further, for each dummy chip 800 covering the optical coupling region 1024, the material of the dummy chip 800 includes silicon or glass.

Further, for each dummy chip 800 covering the optical coupling region 1024, an upper surface of the dummy chip 800 includes an anti-reflective coating. The anti-reflective coating prevents reflection of light at the surface of the dummy chip 800 when light is transmitted from the optical fiber to the dummy chip 800, reducing light loss. The anti-reflective coating is transparent to light.

Further, a plurality of metal connection pillars 1021 are provided in each first semiconductor chip 102, one side surface of each metal connection pillar 1021 is exposed from the surface of the first semiconductor chip 102, and each metal connection pillar 1021 is electrically connected to a corresponding substrate 700 via a second conductive bump 1026. From the above, it can be seen that the method for manufacturing an encapsulation structure provided by embodiments of the present invention includes: providing a semiconductor wafer, the semiconductor wafer including a plurality of first semiconductor chips; for each first semiconductor chip, forming a microlens on a second semiconductor chip or a dummy chip covering an optical coupling region to correct light input into the optical coupling region for optical coupling; wherein the material of the second semiconductor chip or the dummy chip covering the optical coupling region is transparent to light of a predetermined wavelength. Since the microlens can focus light incident on the microlens onto the optical coupling interface, the requirements for subsequent optical coupling precision are significantly reduced, the efficiency of the surface coupling process is improved, and the tolerance for placement alignment errors of die attach equipment is increased.

In other embodiments, an optical fiber structure having third microlenses at its output end is disposed on a dummy chip covering the optical coupling region to correct light input into the optical coupling region for optical coupling. Since the microlens can focus light emitted from the optical fiber structure and transmit it through the dummy chip to the optical coupling interface, the requirements for subsequent optical coupling precision are significantly reduced, the efficiency of the surface coupling process is improved, and the tolerance for placement alignment errors of die attach equipment is increased. Additionally, for the dummy chip covering the optical coupling region, the material of the dummy chip has high transparency to light of a predetermined wavelength, resulting in minimal loss of light after passing through the dummy chip. Furthermore, the dummy chip has a certain thickness, providing support for the optical fiber structure, significantly reducing the stress exerted by the optical fiber structure on the first semiconductor chip, and enhancing the stability of the encapsulation structure.

It should be understood by those skilled in the art that the above disclosures are merely embodiments of the present invention and do not limit the scope of the patent protection sought by the present invention. Equivalent variations made in accordance with the embodiments of the present invention still fall within the scope covered by the claims of the present invention.

## Claims

1. A manufacturing method of an encapsulation structure, the manufacturing method comprising:
providing a semiconductor wafer, the semiconductor wafer comprising a plurality of first semiconductor chips, each of the first semiconductor chips including a first surface and a second surface that are arranged opposite each other, the first surface being provided with an optical coupling region and a non-optical coupling region surrounding the optical coupling region, the optical coupling region comprising an optical coupling interface;
for each of the first semiconductor chips, providing at least one second semiconductor chip corresponding to the first semiconductor chip and fixing the at least one second semiconductor chip on the first surface of the first semiconductor chip, wherein one of the second semiconductor chips corresponding to the first semiconductor chip comprises a dummy region, the dummy region is a circuit-free area, the shape of the dummy region being adapted to the shape of the optical coupling region, and the dummy region of the second semiconductor chip is positioned to cover the optical coupling region, wherein a material of the second semiconductor chip covering the optical coupling region is transparent to light of a predetermined wavelength;
forming a molding layer, wherein the molding layer exposes a surface of each second semiconductor chip facing away from the first semiconductor chip; and
for each of the first semiconductor chips, forming a first microlens on the dummy region of the second semiconductor chip corresponding to the optical coupling region to correct light input into the optical coupling region for optical coupling.

2. The manufacturing method of the encapsulation structure according to claim 1, wherein a curvature of the first microlens and a distance between the first microlens and the optical coupling interface are adjusted to focus light incident on the first microlens onto the optical coupling interface.

3. The manufacturing method of the encapsulation structure according to claim 1, wherein, for each second semiconductor chip covering the optical coupling region, the material of the second semiconductor chip comprises silicon.

4. The manufacturing method of the encapsulation structure according to claim 2, wherein the step of forming the first microlens on the dummy region of the second semiconductor chip corresponding to the optical coupling region for each first semiconductor chip comprises:
forming a photoresist layer on the exposed surface of each second semiconductor chip;
performing patterned photolithography on the photoresist layer using a mask process to form an arc-shaped protrusion structure corresponding to the optical coupling region in the remaining photoresist layer; and
etching the arc-shaped protrusion structure using an etching process to form the first microlens on each second semiconductor chip corresponding to the optical coupling region.

5. The manufacturing method of the encapsulation structure according to claim 1, further comprising:
before fixing the at least one second semiconductor chip on the first surface of the first semiconductor chip, forming a plurality of metal connection pillars in each first semiconductor chip, wherein one side surface of each metal connection pillar is exposed from the surface of the first semiconductor chip.

6. The manufacturing method of the encapsulation structure according to claim 5, wherein fixing the at least one second semiconductor chip on the first semiconductor chip comprises:
fixing the at least one second semiconductor chip on the first surface of the first semiconductor chip using hybrid bonding.

7. The manufacturing method of the encapsulation structure according to claim 6, further comprising:
after forming the first microlens on the dummy region of the second semiconductor chip corresponding to the optical coupling region for each first semiconductor chip, temporarily bonding a surface of each second semiconductor chip facing away from the first semiconductor chip to a first carrier substrate using a temporary bonding adhesive;
thinning a body of the first semiconductor chip on a side away from the at least one second semiconductor chip to expose a surface of the metal connection pillars facing away from the at least one second semiconductor chip; and
after exposing the surface of the metal connection pillars, forming a first conductive bump on the exposed surface of each metal connection pillar.

8. The manufacturing method of the encapsulation structure according to claim 7, further comprising:
after forming the first conductive bump on the exposed surface of each metal connection pillar, debonding the first carrier substrate;
attaching a surface of each second semiconductor chip facing away from the first semiconductor chip to a dicing tape; and
dicing at a position of dicing streets between adjacent first semiconductor chips to obtain a plurality of separated chip encapsulation assemblies, wherein each chip encapsulation assembly comprises one first semiconductor chip and at least one corresponding second semiconductor chip.

9. The manufacturing method of the encapsulation structure according to claim 8, further comprising:
after obtaining the plurality of separated chip encapsulation assemblies, mounting each chip encapsulation assembly onto a corresponding encapsulation substrate;
after mounting the chip encapsulation assembly onto the corresponding encapsulation substrate, mounting an optical fiber structure onto the first microlens.

10. A manufacturing method of an encapsulation structure, the manufacturing method comprising:
providing a semiconductor wafer, the semiconductor wafer comprising a plurality of first semiconductor chips, each of the first semiconductor chips comprising a first surface and a second surface that are arranged opposite each other, the first surface being provided with an optical coupling region and a non-optical coupling region surrounding the optical coupling region, the optical coupling region including an optical coupling interface;
for each of the first semiconductor chips, providing at least one dummy chip corresponding to the first semiconductor chip and fixing the at least one dummy chip on the first surface of the first semiconductor chip, wherein one dummy chip corresponding to the first semiconductor chip covers the optical coupling region, and a material of the dummy chip covering the optical coupling region is transparent to light of a predetermined wavelength;
forming a molding layer, wherein the molding layer exposes a surface of each dummy chip facing away from the first semiconductor chip; and
for each of the first semiconductor chips, forming a second microlens on the dummy chip corresponding to the optical coupling region to correct light input into the optical coupling region for optical coupling.

11. The manufacturing method of the encapsulation structure according to claim 10, wherein for each first semiconductor chip, providing at least one second semiconductor chip corresponding to the first semiconductor chip and fixing the at least one second semiconductor chip on the non-optical coupling region of the first surface of the first semiconductor chip.

12. The manufacturing method of the encapsulation structure according to claim 10, wherein a curvature of the second microlens and a distance between the second microlens and the optical coupling interface are adjusted to focus light incident on the second microlens onto the optical coupling interface.

13. The manufacturing method of the encapsulation structure according to claim 10, wherein, for each dummy chip covering the optical coupling region, the material of the dummy chip comprises silicon or glass.

14. The manufacturing method of the encapsulation structure according to claim 11**,** wherein, in a direction perpendicular to the first surface of the corresponding first semiconductor chip, a top surface of the at least one dummy chip facing away from the first surface is flush with a top surface of the at least one second semiconductor chip facing away from the first surface.

15. The manufacturing method of the encapsulation structure according to claim 13, wherein the step of forming the second microlens on the dummy chip corresponding to the optical coupling region for each first semiconductor chip comprises:
forming a photoresist layer on the exposed surface of each dummy chip;
performing patterned photolithography on the photoresist layer using a mask process to form an arc-shaped protrusion structure corresponding to the optical coupling region in the remaining photoresist layer; and
etching the arc-shaped protrusion structure using an etching process to form the second microlens on each dummy chip corresponding to the optical coupling region.

16. The manufacturing method of the encapsulation structure according to claim 11, further comprising:
before fixing the at least one second semiconductor chip on the first surface of the first semiconductor chip, forming a plurality of metal connection pillars in each first semiconductor chip, wherein one side surface of each metal connection pillar is exposed from the surface of the first semiconductor chip.

17. The manufacturing method of the encapsulation structure according to claim 16, wherein fixing the at least one second semiconductor chip and the at least one dummy chip on the first semiconductor chip comprises:
fixing the at least one second semiconductor chip on the first surface of the first semiconductor chip using thermal compression bonding, reflow soldering, or hybrid bonding; and
fixing each dummy chip on the first semiconductor chip using hybrid bonding.

18. The manufacturing method of the encapsulation structure according to claim 17, further comprising:
after forming the second microlens on the dummy chip corresponding to the optical coupling region for each first semiconductor chip, temporarily bonding the surface of each dummy chip facing away from the first semiconductor chip to a first carrier substrate using a temporary bonding adhesive;
thinning a body of the first semiconductor chip on a side away from the at least one dummy chip to expose a surface of the metal connection pillars facing away from the at least one dummy chip; and
after exposing the surface of the metal connection pillars, forming a second conductive bump on the exposed surface of each metal connection pillar.

19. The manufacturing method of the encapsulation structure according to claim 18, further comprising:
after forming the second conductive bumps on the exposed surface of each metal connection pillar, debonding the first carrier substrate;
attaching the surface of each second semiconductor chip and each dummy chip facing away from the first semiconductor chip to a dicing tape; and
dicing at a position of dicing streets between adjacent first semiconductor chips to obtain a plurality of separated chip encapsulation assemblies, each chip encapsulation assembly comprising one first semiconductor chip and at least one corresponding dummy chip.

20. The manufacturing method of the encapsulation structure according to claim 19, further comprising:
after obtaining the plurality of separated chip encapsulation assemblies, mounting each chip encapsulation assembly onto a corresponding substrate; and
after mounting the chip encapsulation assembly onto the corresponding substrate, mounting an optical fiber structure onto the second microlens.

21. An encapsulation structure, comprising:
a first semiconductor chip comprising a first surface and a second surface that are arranged opposite each other, the first surface being provided with an optical coupling region and a non-optical coupling region surrounding the optical coupling region, the optical coupling region including an optical coupling interface;
at least one second semiconductor chip fixed on the first surface, wherein one second semiconductor chip corresponding to the first semiconductor chip comprises a dummy region, the dummy region is a circuit-free area, the shape of the dummy region is adapted to the shape of the optical coupling region and covering the optical coupling region, and a material of the second semiconductor chip covering the optical coupling region is transparent to light of a predetermined wavelength;
a first microlens disposed on the dummy region of the second semiconductor chip corresponding to the optical coupling region.

22. The encapsulation structure according to claim 21, wherein a curvature of the first microlens and a distance between the first microlens and the optical coupling interface are adjusted to focus light incident on the first microlens onto the optical coupling interface.

23. The encapsulation structure according to claim 21, wherein, for each second semiconductor chip covering the optical coupling region, the material of the second semiconductor chip comprises silicon.

24. The encapsulation structure according to claim 21, wherein a plurality of metal connection pillars are provided in each first semiconductor chip, and one side surface of each metal connection pillar is exposed from the surface of the first semiconductor chip.

25. The encapsulation structure according to claim 24, wherein each metal connection pillar is electrically connected to a corresponding encapsulation substrate via a first conductive bump; the encapsulation structure further comprises an optical fiber structure mounted on a surface of the first microlens facing away from the corresponding first semiconductor chip.

26. An encapsulation structure, comprising:
a first semiconductor chip comprising a first surface and a second surface that are arranged opposite each other, the first surface being provided with an optical coupling region and a non-optical coupling region surrounding the optical coupling region, the optical coupling region including an optical coupling interface;
at least one dummy chip fixed on the first surface, wherein one dummy chip corresponding to the first semiconductor chip covers the optical coupling region, and a material of the dummy chip covering the optical coupling region is transparent to light of a predetermined wavelength;
a molding layer located on the first surface of the first semiconductor chip and encapsulating a side surface of the at least one dummy chip; and
a second microlens formed on the dummy chip corresponding to the optical coupling region.

27. The encapsulation structure according to claim 26, further comprising at least one second semiconductor chip fixed on the non-optical coupling region of the first surface of the first semiconductor chip.

28. The encapsulation structure according to claim 27, wherein, in a direction perpendicular to the first surface of the corresponding first semiconductor chip, a top surface of the at least one dummy chip facing away from the first surface is flush with a top surface of the at least one second semiconductor chip facing away from the first surface.

29. The encapsulation structure according to claim 26, wherein a curvature of the second microlens and a distance between the second microlens and the optical coupling interface are adjusted to focus light incident on the second microlens onto the optical coupling interface.

30. The encapsulation structure according to claim 26, wherein, for each dummy chip covering the optical coupling region, the material of the dummy chip comprises silicon or glass.

31. The encapsulation structure according to claim 26, wherein a plurality of metal connection pillars are provided in each first semiconductor chip, and one side surface of each metal connection pillar is exposed from the surface of the first semiconductor chip.

32. The encapsulation structure according to claim 31, wherein each metal connection pillar is electrically connected to a corresponding substrate via a second conductive bump; the encapsulation structure further comprises an optical fiber structure mounted on a surface of the second microlens facing away from the corresponding first semiconductor chip.

33. An encapsulation structure, comprising:
a first semiconductor chip comprising a first surface and a second surface that are arranged opposite each other, the first surface being provided with an optical coupling region and a non-optical coupling region surrounding the optical coupling region, the optical coupling region including an optical coupling interface;
at least one dummy chip fixed on the first surface, wherein one dummy chip corresponding to the first semiconductor chip covers the optical coupling region, and a material of the dummy chip is transparent to light of a predetermined wavelength; and
an optical fiber structure disposed on the dummy chip corresponding to the optical coupling region, wherein an output end of the optical fiber structure comprises third microlenses, each third microlens corresponding to an optical fiber in the optical fiber structure, configured to focus light emitted from the optical fiber structure onto the optical coupling interface.

34. The encapsulation structure according to claim 33, further comprising a molding layer disposed on the first surface of the first semiconductor chip, the molding layer encapsulating at least a side surface of the at least one dummy chip.

35. The encapsulation structure according to claim 33, further comprising at least one second semiconductor chip fixed on the non-optical coupling region of the first surface of the first semiconductor chip.

36. The encapsulation structure according to claim 33, wherein, for each dummy chip covering the optical coupling region, the material of the dummy chip covering the optical coupling region comprises silicon or glass.

37. The encapsulation structure according to claim 33, wherein, for each dummy chip covering the optical coupling region, an upper surface of the dummy chip covering the optical coupling region comprises an anti-reflective coating.

38. The encapsulation structure according to claim 33, wherein a plurality of metal connection pillars are provided in each first semiconductor chip, one side surface of each metal connection pillar being exposed from the surface of the first semiconductor chip; and each metal connection pillar is electrically connected to a corresponding substrate via a second conductive bump.
